# EUROPEAN PATENT APPLICATION

(11) **EP 4 757 523 A1**
(43) Date of publication of application: **10.06.2026**
(21) Application number: 25217188.9
(22) Date of filing: 20.11.2025
(51) Int. Cl.: H10B 61/00, H10B 63/00, H10N 50/01, H10N 70/20

(54) **SEMICONDUCTOR DEVICE AND METHOD FOR FABRICATING THE SAME**

(30) Priority: 03.12.2024 KR 20240177199
(71) Applicant: SK hynix Inc., Bubal-eub Icheon-si Gyeonggi-do 17336 (KR)
(72) Inventor: DONG, Cha Deok, 17336 Icheon-si, Gyeonggi-do (KR)
(74) Representative: Isarpatent

(57) **Abstract**

A semiconductor device includes a first conductive line including an upper portion of a carbon-based thin layer; a variable resistance layer disposed over the first conductive line; a selector layer disposed over the variable resistance layer and a second conductive line disposed over the selector layer.

## Description

### BACKGROUND

### 1. Field

Embodiments of the present disclosure relate to a semiconductor technology, and more particularly, to a semiconductor device including a variable resistance element and a selector, and a method for fabricating the semiconductor device.

### 2. Description of the Related Art

Recent demands for miniaturization, low power consumption, high performance, and diversification of electronic devices require semiconductor devices capable of storing data in diverse electronic devices, such as computers, portable communication devices and the like, and researchers and the industry are studying to develop such semiconductor devices. Such semiconductor devices include those capable of storing data by using the characteristics of switching between different resistance states according to the applied voltage or current, such as a Resistive Random Access Memory (RRAM), a Phase-change Random Access Memory (PRAM), a Ferroelectric Random Access Memory (FRAM), a Magnetic Random Access Memory (MRAM), an E-fuse and the like.

### SUMMARY

Embodiments of the present disclosure are directed to a semiconductor device and a method for fabricating the semiconductor device capable of increasing the degree of completion of the stacked structure of the variable resistance layer by directly depositing the variable resistance layer in the upper portion of the first conductive line, sufficiently performing a wet cleaning process during the patterning of the second conductive line by forming the second conductive line in the upper portion of the selector layer, and improving the electrical short between the second conductive lines.

Furthermore, embodiments of the present disclosure are directed to a semiconductor device and a method for fabricating the semiconductor device capable of controlling the occurrence of shunt failure during the patterning of the variable resistance layer and preventing deterioration of the selector layer by depositing a conductive thin layer containing carbon in the upper portions of the first conductive line and the selector layer.

In accordance with an embodiment of the present disclosure, a semiconductor device includes a first conductive line including an upper portion of a carbon-based thin layer; a variable resistance layer disposed over the first conductive line; a selector layer disposed over the variable resistance layer; and a second conductive line disposed over the selector layer.

In accordance with another embodiment of the present disclosure, a method for fabricating a semiconductor device includes forming a variable resistance layer over a first conductive line having an upper portion of a carbon-based thin layer and a lower portion of a conductive material; patterning the variable resistance layer to have a pillar shape; forming a selector layer over the variable resistance layer; performing a first lithography process and a first etching process onto the selector layer, and performing a second lithography process and a second etching process onto the selector layer to provide a patterned selector layer; and forming a second conductive line over the patterned selector layer.

### BRIEF DESCRIPTION OF THE DRAWINGS

FIG. 1A is a perspective view illustrating a semiconductor device according to a comparative example.
FIG. 1B is a cross-sectional view illustrating the semiconductor device according to the comparative example.
FIG. 2 is a perspective view illustrating a semiconductor device in accordance with an embodiment of the present disclosure.
FIGS. 3A to 3H illustrate a method for fabricating a semiconductor device in accordance with an embodiment of the present disclosure.
FIGS. 4A and 4B illustrate a semiconductor device in accordance with another embodiment of the present disclosure.

### DETAILED DESCRIPTION

Hereinafter, the various embodiments of the present disclosure will be described in detail with reference to the attached drawings.

Embodiments of the present disclosure will be described below in more detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present disclosure to those skilled in the art. Throughout this disclosure, like reference numerals refer to like parts throughout the various figures and embodiments of the present disclosure.

The drawings are not necessarily to scale and in some instances, proportions may have been exaggerated to clearly illustrate features of the embodiments. When a first layer is referred to as being "on" a second layer or "on" a substrate, it not only refers to a case where the first layer is formed directly on the second layer or the substrate but also a case where a third layer exists between the first layer and the second layer or the substrate. When a first element is referred to as being "over" a second element, it not only refers to a case where the first element is formed directly on the second element but also a case where a third element exists between the first element and the second element.

It will be understood that, although the terms "first", "second", "third", and so on may be used herein to describe various elements, these elements are not limited by these terms. These terms are used to distinguish one element from another element. Thus, a first element described below could also be termed as a second or third element without departing from the field and scope of the present disclosure.

In addition, it will also be understood that when an element is referred to as being "between" two elements, it may be the only element between the two elements, or one or more intervening elements may also be present.

As used herein, a "layer" refers to a material portion including a region having a thickness. A layer may extend over the entirety of an underlying or overlying structure, or may have an extent less than the extent of an underlying or overlying structure. Further, a layer may be a region of a homogeneous or inhomogeneous continuous structure that has a thickness less than the thickness of the continuous structure. For example, a layer may be located between any pair of horizontal planes between, or at, a top surface and a bottom surface of the continuous structure. A layer may extend horizontally, vertically, and/or along a tapered surface. A substrate may be a layer, may include one or more layers therein, or may have one or more layer thereupon, thereabove, and/or therebelow.

It should be understood that the drawings are simplified schematic illustrations of the described devices and may not include well known details to avoid obscuring the features of the embodiments.

It should also be noted that features present in one embodiment may be used with one or more features of another embodiment without departing from the scope of the present disclosure.

As used herein, singular forms are intended to include the plural forms as well, unless the context clearly indicates otherwise.

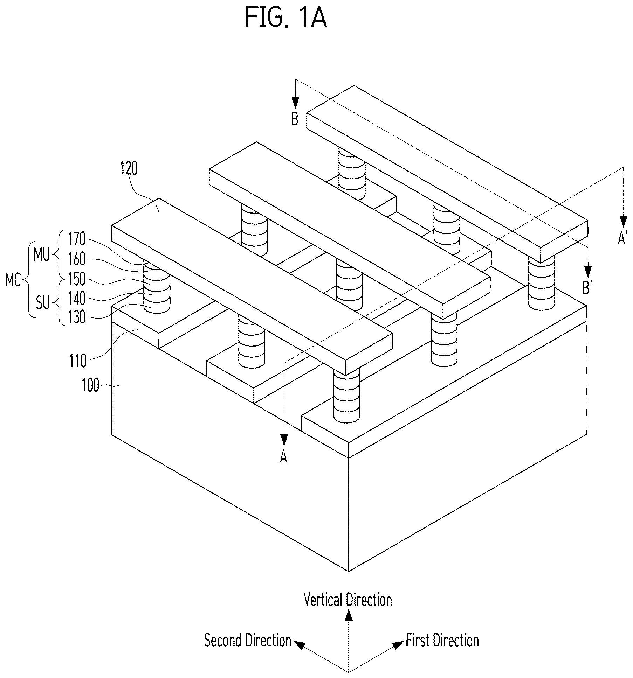

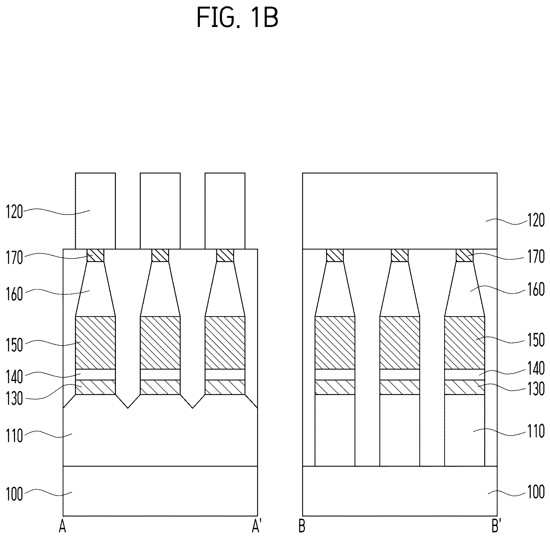

Before describing the semiconductor device in accordance with an embodiment of the present disclosure, a semiconductor device according to a comparative example is described first in order to more clearly reveal the stacked structure of a variable resistance layer and a selector layer in accordance with the embodiment of the present disclosure and the resulting effect. FIG. 1A is a perspective view illustrating a semiconductor device according to a comparative example. FIG. 1B is a cross-sectional view taken along line A-A' and B-B' shown in FIG. 1A.

Referring to FIGS. 1A and 1B, the semiconductor device according to the comparative example may include a substrate 100, a plurality of first conductive lines 110 disposed over the substrate 100 and extending in a first direction, a plurality of second conductive lines 120 disposed over the first conductive lines 110 and extending in a second direction intersecting with the first direction, and a plurality of memory cells MC disposed to respectively overlap with the intersection areas between the first conductive lines 110 and the second conductive lines 120. The first direction and the second direction may mean directions substantially parallel to the surface of the substrate 100. A direction substantially perpendicular to the surface of the substrate 100 will be, hereinafter, referred to as a vertical direction.

Each of the plurality of memory cells MC may include a memory unit MU, which is a portion where data are substantially stored, and a selector unit SU that controls access to the memory unit MU. For example, the memory cell MC may include a stacked structure of a lower electrode layer 130, a selector layer 140, an intermediate electrode layer 150, a variable resistance layer 160, and an upper electrode layer 170. The lower electrode layer 130, the selector layer 140, and the intermediate electrode layer 150 may form the selector unit SU. The intermediate electrode layer 150, the variable resistance layer 160, and the upper electrode layer 170 may form the memory unit MU. The intermediate electrode layer 150 may be shared by the selector unit SU and the memory unit MU.

An SC-MRAM, as illustrated in the comparative example, may be fabricated by performing two line patterning processes and two pillar patterning processes on the first conductive line 110, the selector layer 140, the variable resistance layer 160, and the second conductive line 110 having the same design rule. In particular, the pillar patterning process may require repeatedly stacking diverse hard masks, which significantly increases the total number of processes. As the number of processes increases, it takes a longer time to fabricate a semiconductor device and more costs, and the possibility of errors occurring may increase due to the process complexity. Further, there may be a concern in the alignment with a lower layer during the pillar patterning process. The SC-MRAM may be formed of multiple layers, and precise alignment between layers is very important. A small error in the alignment process may significantly affect the performance of the whole device, which may lead to a serious concern, especially, in a high-density semiconductor device. When patterning multiple layers including a metal layer of the SC-MRAM, metal residue may remain in the neighboring cells during an etching process. Such metal residue may cause a bridge phenomenon which may cause an electrical short. The occurrence of the bridge phenomenon may increase the electrical interference between cells, decreasing the reliability of a memory device.

In order to address the concern of the semiconductor device according to the comparative example, a semiconductor device in accordance with an embodiment of the present disclosure may include a variable resistance layer that is formed by using an ion beam etching process below a selector layer, and a second conductive line that is formed over the selector layer. This may increase the degree of completion of the stacked structure of the variable resistance layer, enable a wet cleaning process to be performed sufficiently during the patterning of the second conductive line, and improve the electrical short between the second conductive lines.

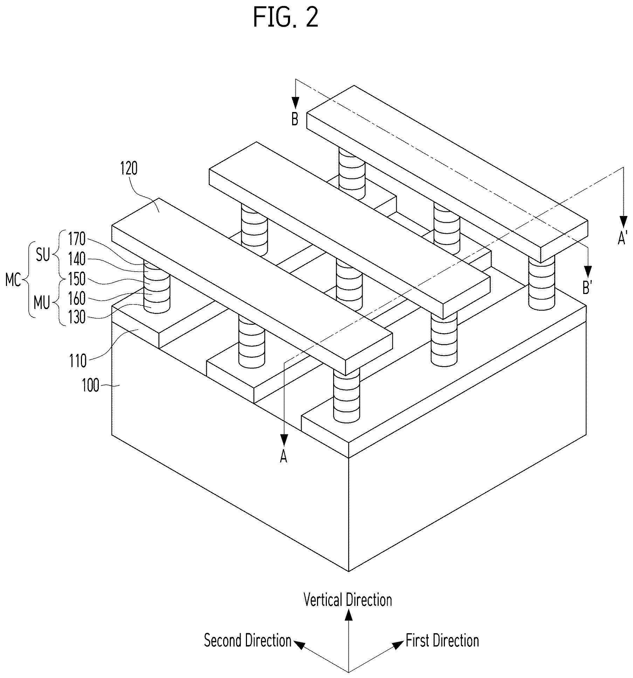

FIG. 2 is a perspective view illustrating a semiconductor device in accordance with an embodiment of the present disclosure. Referring to FIG. 2, in the layer structure of a memory cell MC in accordance with the embodiment of the present disclosure, a variable resistance layer 160 may be disposed over a first conductive line 110, and a selector layer 140 may be disposed over the variable resistance layer 160.

The semiconductor device may include a substrate 100, a plurality of first conductive lines 110 disposed over the substrate 100 and extending in a first direction, a plurality of second conductive lines 120 disposed over the first conductive lines 110 and extending in a second direction intersecting with the first direction, and a plurality of memory cells MC disposed between the first conductive lines 110 and the second conductive lines 120 to overlap with the intersection areas between the first conductive lines 110 and the second conductive lines 120.

The substrate 100 may include a semiconductor material, such as silicon. Further, a required predetermined lower structure (not shown) may be formed in the substrate 100. For example, an integrated circuit for driving the first conductive line 110 and/or the second conductive line 120 may be formed in the substrate 100.

The first conductive lines 110 may be disposed spaced apart from each other in the second direction. The first conductive lines 110 may include conductive material(s), for example, metals such as platinum (Pt), tungsten (W), aluminum (Al), copper (Cu), tantalum (Ta) and the like; metal nitrides such as titanium nitride (TiN), tantalum nitride (TaN) and the like; or combinations thereof. Further, the first conductive lines 110 may have a single-layer structure or a multi-layer structure.

The second conductive lines 120 may be disposed spaced apart from each other in the first direction. The second conductive lines 120 may include diverse conductive material(s), for example, metals such as platinum (Pt), tungsten (W), aluminum (Al), copper (Cu), tantalum (Ta) and the like; metal nitrides such as titanium nitride (TiN), tantalum nitride (TaN) and the like; or combinations thereof. The second conductive lines 120 may have a single-layer structure or a multi-layer structure.

The lower electrode layer 130 and the upper electrode layer 170 may be disposed at both ends of the memory cell MC, that is, at the bottom and top ends of the memory cell MC, respectively, and may function to transfer a voltage or current required for an operation of the memory cell MC. The lower electrode layer 130 may be electrically connected to the variable resistance layer 160, and the upper electrode layer 170 may be electrically connected to the selector layer 140. The intermediate electrode layer 150 may function to electrically connect the selector layer 140 and the variable resistance layer 160 to each other while physically disconnecting them from each other. The lower electrode layer 130, the intermediate electrode layer 150, and the lower electrode layer 170 may be formed of the same material, or may be formed of different materials. Each of the lower electrode layer 130, the intermediate electrode layer 150, and the upper electrode layer 170 may include conductive material(s), for example, metals such as platinum (Pt), tungsten (W), aluminum (Al), copper (Cu), tantalum (Ta), titanium (Ti) and the like; metal nitrides such as titanium nitride (TiN), tantalum nitride (TaN) and the like; or combinations thereof. Further, each of the lower electrode layer 130, the intermediate electrode layer 150, and the upper electrode layer 170 may include a carbon electrode. The lower electrode layer 130, the intermediate electrode layer 150, and the lower electrode layer 170 may have the same thickness or different thicknesses.

The selector layer 140 may have a function of preventing current leakage that may occur between the memory cells MC that share the first conductive line 110 or the second conductive line 120 while controlling access to the variable resistance layer 160. To this end, the selector layer 140 may have the threshold switching characteristics of blocking off the current or holding the current to hardly flow when the level of the voltage supplied to the upper and lower portions of the selector layer 140 is lower than a predetermined threshold voltage level, and then letting the current flow rapidly at a voltage level which is equal to or higher than the threshold voltage level. The selector layer 140 may be turned on at a voltage level which is equal to or higher than the threshold voltage level and turned off at a voltage level which is lower than the threshold voltage level.

The selector layer 140 may include an Ovonic Threshold Switching (OTS) material, such as a diode, a chalcogenide-based material and the like, a Mixed Ionic Electronic Conducting (MIEC) material, such as a metal-containing chalcogenide-based material, a Metal Insulator Transition (MIT) material, such as NbO₂, VO₂, and the like, or a tunneling dielectric material having a relatively wide band gap, such as SiO₂, Al₂O₃, and the like.

Further, the selector layer 140 may include a dielectric material that is doped with a dopant. The dielectric material may include a silicon-containing dielectric material such as silicon oxide, silicon nitride, silicon oxynitride and the like, a dielectric metal oxide, a dielectric metal nitride, or a combination thereof. The dopant may function to capture a conductive carrier migrating in the dielectric material or creating a trap site that provides a path for the captured conductive carrier to migrate again. To form the trap sites, diverse elements capable of causing an energy level that may accommodate conductive carriers in the dielectric material may be used as the dopant. For example, when the dielectric material contains silicon, the dopant may include a metal having a different valence from the valence of silicon, such as gallium (Ga), boron (B), indium (In), phosphorus (P), arsenic (As), antimony (Sb), germanium (Ge), carbon (C), tungsten (W), or a combination thereof. Further, when the dielectric material contains a metal, the dopant may include a metal having a different valence from the valence of the metal or silicon. For example, the selector layer 140 may include silicon dioxide (SiO₂) that is doped with arsenic (As) or germanium (Ge). When a voltage which is equal to or higher than the threshold voltage level is applied to the selector layer 140 including the dielectric material that is doped with the dopant, an on-state in which the current flows through the selector layer 140 may be realized as the conductive carriers migrate through the trap sites, and when the voltage applied to the selector layer 140 is decreased to a voltage level which is lower than the threshold voltage, an off-state in which the current does not flow because the conductive carriers do not migrate may be realized.

The variable resistance layer 160 may be a portion that functions to store data in a memory cell MC. To this end, the variable resistance layer 160 may have the variable resistance characteristics of switching between different resistance states according to the applied voltage. The variable resistance layer 160 may have a single-layer structure or a multi-layer structure including diverse materials used in a Resistive Random Access Memory (RRAM), a Phase-change Random Access Memory (PRAM), a Ferroelectric Random Access Memory (FRAM), a Magnetic Random Access Memory (MRAM) and the like, for example, metal oxides such as transition metal oxides, perovskite-based materials and the like, phase change materials such as chalcogenide-based materials, ferroelectric materials, ferromagnetic materials, and the like. For example, the variable resistance layer 160 may include a magnetic tunnel junction structure that may store data by switching between different resistance states by changing the magnetization direction. When the variable resistance layer 160 has a high resistance state, the memory cell MC may store, for example, data '0', and when the variable resistance layer 160 has a low resistance state, the memory cell MC may store, for example, data '1'.

The memory cell MC may have a pillar shape that overlaps with the intersection area between the first conductive lines 110 and the second conductive lines 120. In this figure, the memory cell MC may be illustrated to have a cylindrical shape, but the field and scope of the present disclosure are not limited thereto, and the memory cell MC may have diverse shapes such as a square pillar, an elliptical pillar and the like.

Further, the layer structure of the memory cell MC is not limited to what is illustrated, and one or more among the layers may be omitted, or one or more layers may be added. For example, one or more among the lower electrode layer 130, the intermediate electrode layer 150, and the upper electrode layer 170 may be omitted. For example, when the lower electrode layer 130 is omitted, the first conductive line 110 may perform the function of the lower electrode layer 130 instead of the omitted lower electrode layer 130, and when the upper electrode layer 170 is omitted, the second conductive line 120 may perform the function of the upper electrode layer 170 instead of the omitted upper electrode layer 170. Further, one or more layers (not shown) may be added to the memory cell MC to improve the process or the characteristics of the memory cell MC.

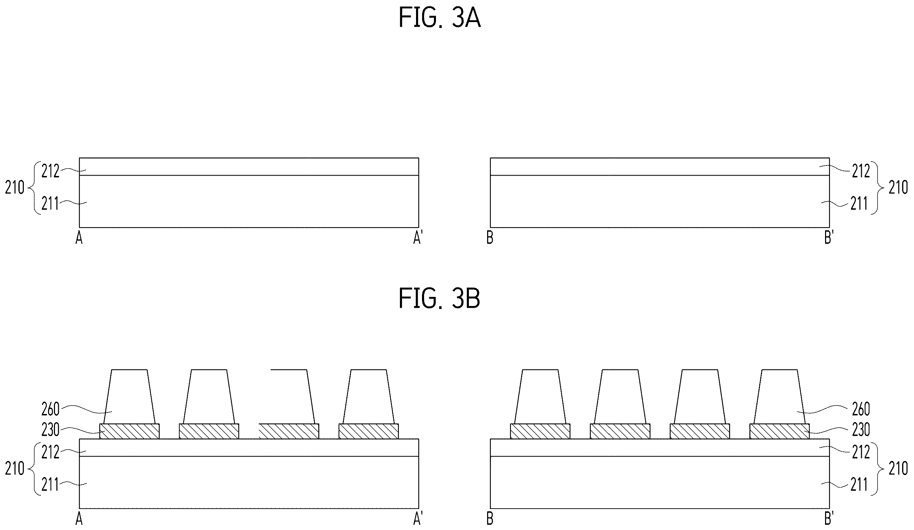

The method for fabricating the semiconductor device in accordance with the embodiment of the present disclosure described above may be described below with reference to FIGS. 3A to 3H. As for the detailed description on the constituent elements also appearing in the embodiment illustrated in FIG. 2, the detailed description may be omitted.

Referring to FIG. 3A, a first conductive line 210 may be formed over a substrate (not shown) in which a predetermined lower structure is formed. The first conductive line 210 may be formed by forming a gap-fill layer (not shown) having a trench for forming the first conductive line 210 over the substrate, depositing a conductive layer for forming the first conductive line 210 in the trench.

The lower portion of the first conductive line 210 may include a metallic material which is a conductive material, and the upper portion of the first conductive line 210 may include carbon or a carbon-based material. A first metal layer 211 may be formed by depositing a metal material such as tungsten (W), titanium nitride (TiN), titanium (Ti), aluminum (Al), tantalum (Ta), or cobalt (Co) over the substrate by using a method such as sputtering or Chemical Vapor Deposition (CVD). After the first metal layer 211 is formed, the surface may be activated through a plasma treatment to increase the adhesion of a carbon-based thin layer to be deposited thereon, and to remove impurities and planarize the surface, or surface contaminants may be removed through a wet cleaning process. A first carbon-based thin layer 212 including carbon or a carbon-based material, such as graphite, carbon nanotube, graphene, doped carbon, or amorphous carbon, may be deposited over the first metal layer 211 by a Chemical Vapor Deposition (CVD) process, a Physical Vapor Deposition (PVD) process, or an Atomic Layer Deposition (ALD) process. Further, when a variable resistance layer 260 is formed over a non-flat surface, the characteristics of the variable resistance layer 260 may be deteriorated. Therefore, a planarization process, such as an etch-back process or a Chemical Mechanical Polishing (CMP) process, may be performed onto the first carbon-based thin layer 212 to form a stable structure of the variable resistance layer 260. Further, the planarization process may be performed by applying a material having excellent surface roughness to the first carbon-based thin layer 212 to increase the density.

Referring to FIG. 3B, a lower electrode layer material layer and a variable resistance layer material layer may be formed over the first conductive line 210. Subsequently, a hard mask layer may be formed over the variable resistance layer material layer, and the lower electrode layer material layer and the variable resistance layer material layer may be patterned into pillar shapes by using the hard mask layer as an etching barrier. The hard mask layer may include a dielectric material, polysilicon (Poly-Si), or a combination thereof, and the hard mask layer may have a single-layer structure or a multi-layer structure. The dielectric material may include an oxide, a nitride, or a combination thereof. For example, the hard mask layer may include SiO₂, SiN₄, SiOCN, SiON, polysilicon (Poly-Si), or a combination thereof.

As a result of the patterning process, the lower electrode layer 230 and the variable resistance layer 260 of a pillar shape may be formed. The upper portion of the first conductive line 210 may be partially recessed, and it is important to control the occurrence of a shunt failure that may occur as the material of the first metal layer 211 in the lower portion that is etched and lost may be re-deposited on the sidewall of the variable resistance layer 260. The occurrence of this shunt failure may be controlled more easily due to the presence of the first carbon-based thin layer 212 in the upper portion of the first conductive line 210.

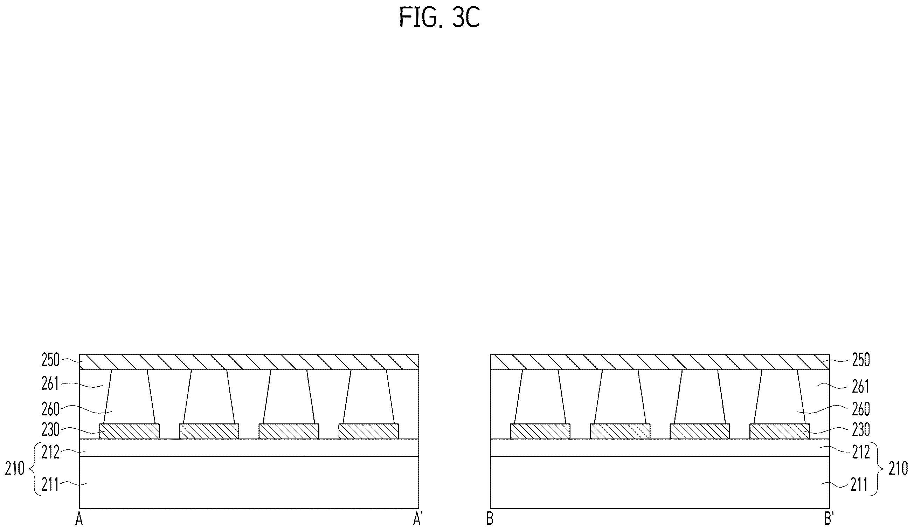

Referring to FIG. 3C, after the lower electrode layer 230 and the variable resistance layer 260 are formed, an inter-layer capping layer 261 may be formed to fill the space between the lower electrode layer 230 and the variable resistance layer 260 to effectively prevent the interference between the memory cells. The inter-layer capping layer 261 may include a dielectric material, polysilicon (Poly-Si), or a combination thereof, and the inter-layer capping layer 261 may be formed to have a single-layer structure or a multi-layer structure. An oxide, a nitride, or a combination thereof may be used as the dielectric material. For example, the inter-layer capping layer 261 may include SiO₂, SiN₄, SiOCN, SiON, polysilicon (Poly-Si), or a combination thereof. Subsequently, after the upper surfaces of the inter-layer capping layer 261 and the variable resistance layer 260 are planarized, an intermediate electrode layer material layer 250 may be formed on the upper surfaces of the inter-layer capping layer 261 and the variable resistance layer 260. By planarizing the intermediate electrode layer material layer 250 before a selector layer material layer 240 is deposited, the intermediate electrode layer material layer 250 may have a planarized upper surface. Through this process, it is possible to provide a favorable effect on the formation of the variable resistance layer 260 including an MTJ whose crystal growth and deposition according to the crystallization direction are important, thereby contributing to improving the characteristics of the memory cell.

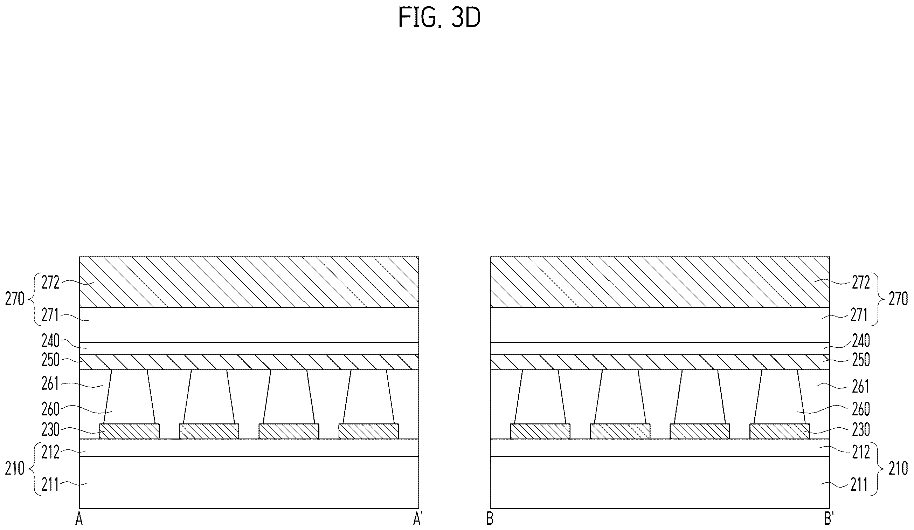

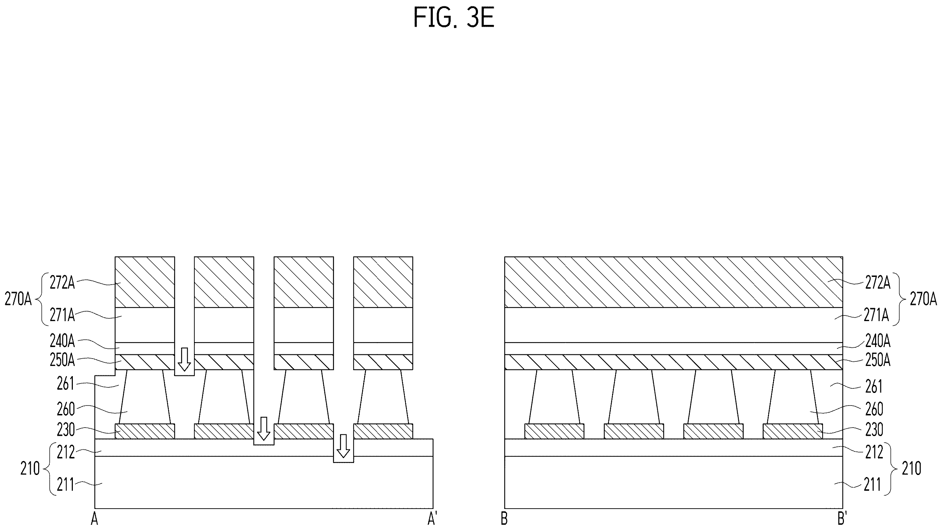

Referring to FIG. 3D, the selector layer material layer 240 and an upper electrode layer material layer 270 may be formed over the intermediate electrode layer material layer 250. To prevent the upper portion of the selector layer material layer 240 from directly contacting the second metal layer material layer 272 of the upper electrode layer material layer 270, a second carbon-based thin layer material layer 271 including carbon or a carbon-based material, such as graphite, carbon nanotube, graphene, doped carbon, or amorphous carbon, may be deposited in the upper portion of the selector layer material layer 240 by a Chemical Vapor Deposition (CVD) process, a Physical Vapor Deposition (PVD) process, or an Atomic Layer Deposition (ALD) process. A second carbon-based thin layer (271A in FIG. 3E) may function as a physical or chemical barrier between a selector layer (240A in FIG. 3E) formed later and a second metal layer (272A in FIG. 3E) of the upper electrode layer (270A in FIG. 3E), thereby suppressing the reaction or diffusion between the second metal layer 272A and the selector layer 240A. When the selector layer 240A does not directly contact the second metal layer 272A, changes in the properties that may be caused due to the diffusion or chemical reaction of the metal atoms that may occur in the selector layer 240A may be reduced. Through this process, the structural and electrical characteristics of the selector layer 240A may be maintained, and the performance and stability of the entire memory cells may be increased, preventing deterioration of the selector layer 240A.

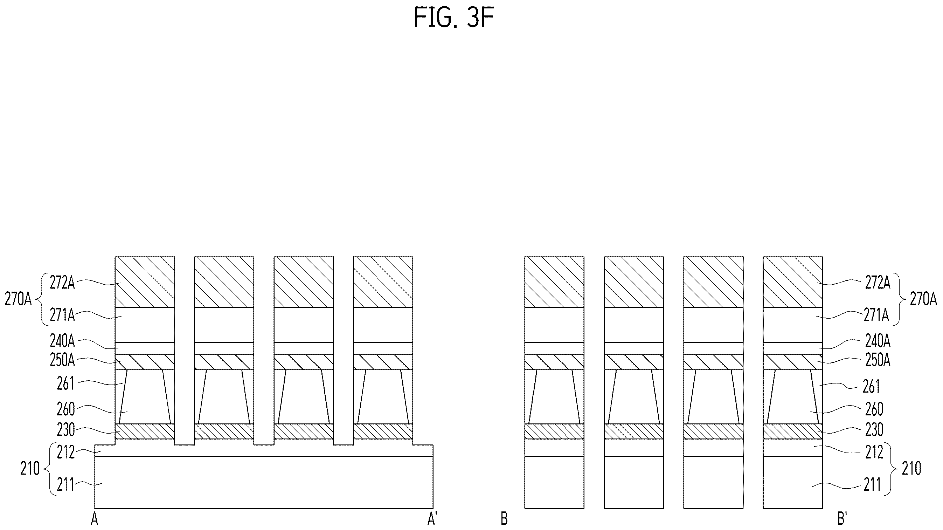

Referring to FIGS. 3E and 3F, a first lithography process may be performed onto the stacked structure illustrated in FIG. 3D to perform a first patterning process onto the selector layer material layer 240, and then a second lithography process may be performed to perform a second patterning process onto the selector layer material layer 240 to finally form a patterned selector layer 240A.

Referring to FIG. 3E, the first lithography process may be performed onto the stacked structure of FIG. 3D to perform a first patterning process and an etching process onto the selector layer material layer 240. In this process, the first patterning process and the etching process may be very important and may have a great influence on the accuracy of the pattern and the final quality of the process. In the first patterning process and the etching process, the etching of the peripheral area of the variable resistance layer 260 may be important. When the etching process is performed in this stage, the etching process may be performed to the height where the variable resistance layer 260 exists (the first arrow from the left side in FIG. 3E), to a portion of the first carbon-based thin layer 212 in the upper portion of the first conductive line 210 (the second arrow from the left side in FIG. 3E), or to the first metal layer 211 which is the lower portion of the first conductive line 210 (the third arrow from the left side in FIG. 3E).

When the etching process is performed to the height where the variable resistance layer 260 exists, it is effective in maintaining the structural stability of the variable resistance layer 260 and preventing unnecessary damage. Since the variable resistance layer 260 is a very sensitive structure, the electrical characteristics of the variable resistance layer 260 may be preserved by preventing excessive etching through an etching stop. When the etching process is performed to a portion of the first carbon-based thin layer 212 which is the upper portion of the first conductive line 210, it may be favorable to removing the residues of the etching process of the variable resistance layer 260. Since the residues remaining after the etching process of the variable resistance layer 260 may adversely affect the performance of the memory cell in the long term, it is desirable to remove the residues by performing the etching process to the upper portion of the first conductive line 210. This may increase the reliability of the process and help maintain the accuracy of the electrical connection. When the etching process is performed to the first metal layer 211 which is the lower portion of the first conductive line 210, the etching process may be performed so deep that a pattern may be formed to the lower portion of the first conductive line 210. In this case, it is particularly advantageous to reliably separate the variable resistance layer 260 and the first conductive line 210 from each other and remove the residues. Etching to the lower portion of the first conductive line 210 may minimize the possibility of the residue remaining, thereby further ensuring long-term performance and reliability of the memory cell.

FIG. 3F shows a stacked structure obtained after the etching process is completed to a portion of the first carbon-based thin layer 212 which is the upper portion of the first conductive line 210 in FIG. 3E. Referring to FIG. 3F, the first conductive line 210 may be patterned using a mask pattern (not shown) of a line shape extending in the first direction. Athe second lithography process may be performed onto the stacked structure of FIG. 3E to perform a second patterning process and an etching process onto the selector layer material layer 240, thereby forming a patterned selector layer 240A. The second patterning process and the etching process may etch at least a portion of the first conductive line 210. This process may be essential for the pattern to be precisely formed through the first patterning process and the etching process and for accurate connection with the first conductive line 210. In the second patterning process and the etching process, a lithography process may be performed again to further delicately adjust the structure which is formed as a result of the first patterning process and the etching process. During this process, a conductive line pattern may be formed by using a mask, and the first conductive line 210 may be precisely etched. In this operation, electrical connection of the first conductive line 210 may be secured. In the second patterning process and the etching process, the etching process may be performed to at least a portion of the first conductive line 210, so that some of the materials in the upper portion of the first conductive line 210 may be removed and a desired pattern may be formed. By performing the etching process to a portion of the first conductive line 210, the upper pattern and the first conductive line 210 may be reliably connected, minimizing unnecessary residues or damage, and ensuring the electrical characteristics of the memory cell.

The upper electrode layer material layer 270 including the intermediate electrode layer material layer 250, the second carbon-based thin layer material layer 271, and the second metal layer material layer 272 may be etched together with the selector layer material layer 240 to form a stacked structure in which the intermediate electrode layer 250A, the selector layer 240A, and the upper electrode layer 270A including the second carbon-based thin layer 271A and the second metal layer 272 are sequentially stacked.

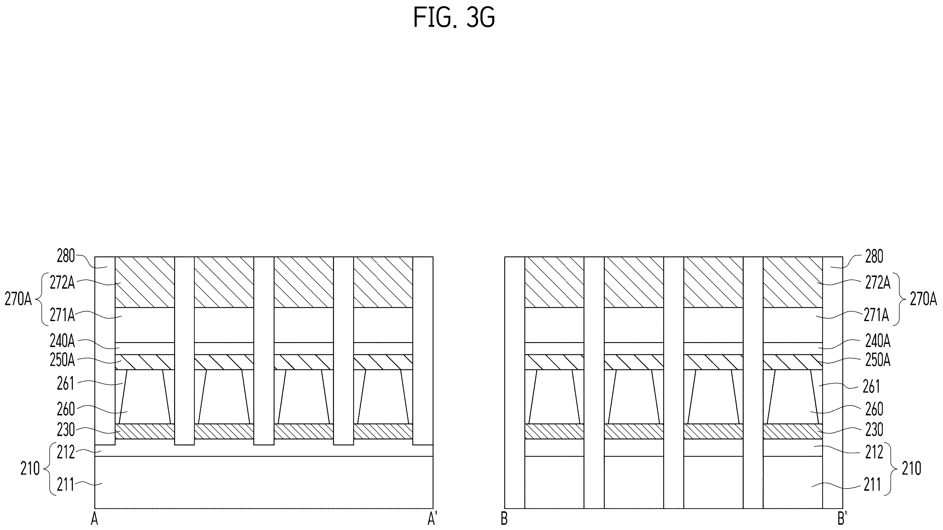

Referring to FIG. 3G, the sidewall of the patterned variable resistance layer 260 and the sidewall of the patterned selector layer 240A may be aligned, and a gap-fill layer 280 may be formed to fill the space between the aligned variable resistance layer 260 and the selector layer 240A. The gap-fill layer 280 may include a dielectric material. The dielectric material may include an oxide, a nitride, or a combination thereof. For example, the gap-fill layer 280 may include silicon oxide, silicon nitride, silicon oxynitride, silicon oxide carbon nitride, or a combination thereof, for example, SiO₂, SiN₄, SiOCN, SiON, or a combination thereof.

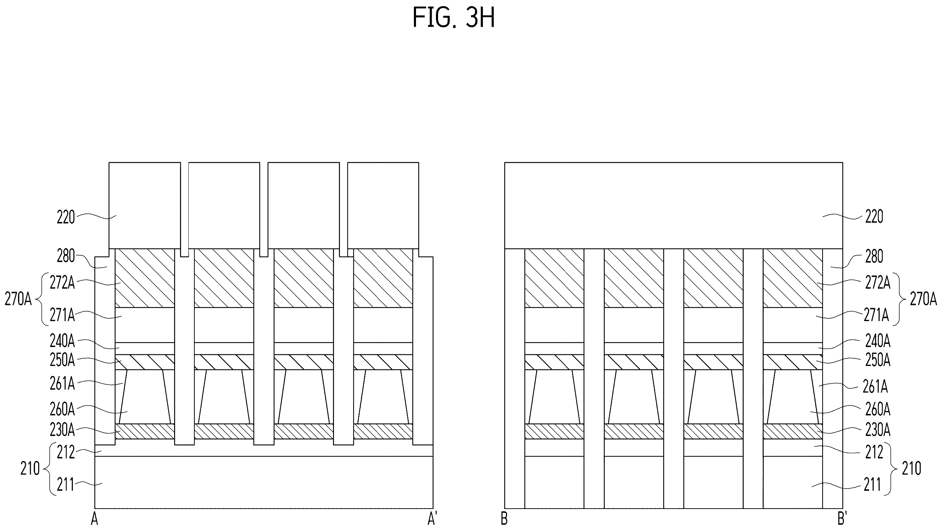

Referring to FIG. 3H, a second conductive line 220 may be formed in the upper portion of the memory cell. The second conductive line 220 may be formed by forming a trench for forming the second conductive line 220, depositing a conductive layer for forming the second conductive line 220 in the trench, and etching the conductive layer by using a mask pattern (not shown) having a line shape extending in the second direction. The second conductive line 220 may be patterned in a direction which is at approximately 90 degrees with respect to the first conductive line 210. The first conductive line 210 may be formed to extend in the first direction of FIG. 2, and the second conductive line 220 may be formed to extend in the second direction of FIG. 2. In this way, a semiconductor device having a cross-point structure in which a memory cell is disposed between the first conductive line 210 and the second conductive line 220 intersecting with each other may be fabricated.

Through the above process, the semiconductor device in accordance with the embodiment of the present disclosure may be fabricated. Referring back to FIG. 3H, the semiconductor device may be fabricated to include a first conductive line 210 including a first metal layer 211 and a first carbon-based thin layer 212, a lower electrode layer 230, a variable resistance layer 260, an inter-layer capping layer 261, an intermediate electrode layer 250A, a selector layer 240A, an upper electrode layer 270A including a second carbon-based thin layer 271 and a second metal layer 272, a gap-fill layer 280, and a second conductive line 220.

According to the method for fabricating a semiconductor device described above, since the lower electrode layer 230, the variable resistance layer 260, the intermediate electrode layer 250A, the selector layer 240A, and the upper electrode layer 270A are patterned in a row, the number of the processes may be reduced compared to the existing patterning methods, which may lead to a decrease in the production costs. By directly depositing the variable resistance layer 260 in the upper portion of the first conductive line 210 that is not patterned but only planarized, the influence of the heat, plasma, or chemical reaction caused during the patterning of the selector layer 240A on the variable resistance layer 260 may be minimized, and the direct alignment between the variable resistance layer 260 and the first conductive line 210 may reduce the alignment error between the layers and increase the degree of completion of the structure. Further, by forming the variable resistance layer 260 below the selector layer 240A, it is possible to deposit the variable resistance layer 260 before the selector layer 240A is formed. This may simplify the fabrication process, improve the reliability of the fabrication process, and preserve the electrical characteristics of the variable resistance layer 260 well.

According to the embodiment of the present disclosure, by forming the second conductive line 220 in the upper portion of the selector layer 240A, it is possible to freely use a wet cleaning process as much as needed during the patterning of the second conductive line 220. The wet cleaning process may be effective in removing impurities or residues remaining during the patterning process. As a result, the clarity and quality of the pattern may be improved. Since the selector layer 240A is not affected during the cleaning process, the selector layer 240A may be efficiently cleaned without any damage to the selector layer 240A. Further, since there is no concern that the selector layer 240A may detach from the lower portion of the second conductive line 220 or may be damaged, residues or contamination that may occur during the wet cleaning process may be cleanly removed without affecting the selector layer 240A. As a result, the performance deterioration or occurrence of defects that may be caused due to the residues which may remain during the patterning process may be reduced, and the reliability of the memory device may be improved. Further, according to this embodiment of the present disclosure, the interaction with the selector layer 240A during the patterning process of the second conductive line 220 may be minimized. After the patterning of the second conductive line 220 is completed, an additional process or a cleaning process may be performed in the upper portion of the selector layer 240A as a separate process. This may reduce the complexity of the patterning process and facilitate the process control. Further, since the second conductive line 220 is formed in the upper portion of the selector layer 240A, the contact area between the selector layer 240A and the second conductive line 220 may be optimized, which may improve the quality of electrical signal transmission.

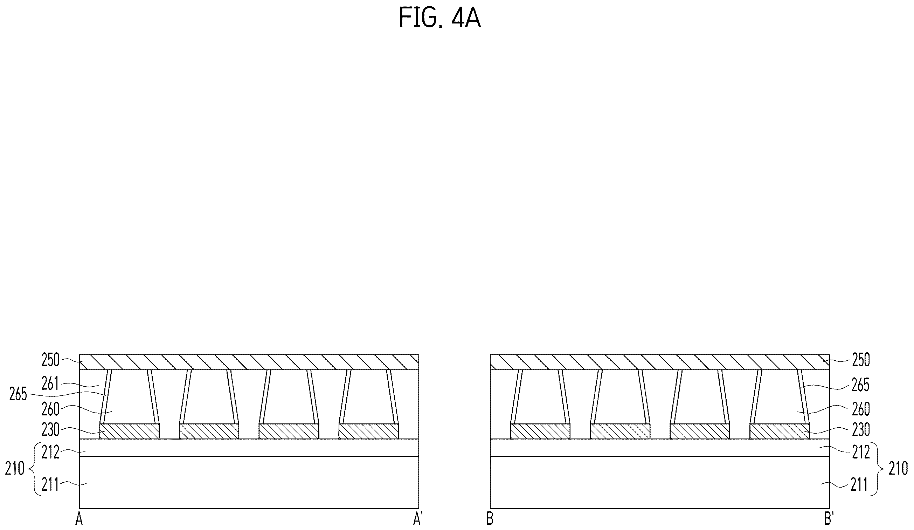

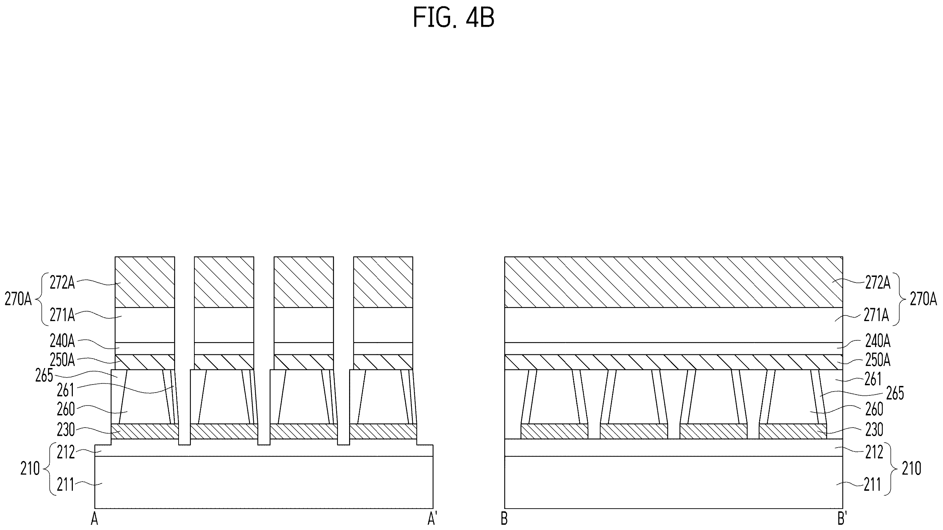

FIGS. 4A and 4B illustrate a semiconductor device in accordance with another embodiment of the present disclosure.

Referring to FIG. 4A, a spacer 265 may be formed on the sidewall of the variable resistance layer 260 in the process result of FIG. 3B. The spacer 265 may include a high-density layer with excellent etching selectivity, for example, a material selected from the group including silicon nitride, tantalum nitride, tungsten, titanium nitride, aluminum oxide, hafnium oxide, and platinum.

Referring to FIG. 4B, the spacer 265 formed on the sidewall of the variable resistance layer 260 may solve the problem of misalignment that may occur in the etching process during the patterning of the selector layer 240A. The side surface portion of the spacer 265 and the side surface portion of the selector layer 240A may be self-aligned.

When the spacer 265 is formed on the sidewall of the variable resistance layer 260, it may be dependent on the relative alignment with the spacer 265 during the etching process. Therefore, the pattern of the selector layer 240A may be automatically aligned with the pattern of the variable resistance layer 260. This may reduce the overlay problem and enable self-alignment. In the subsequent process, when the selector layer 240A is patterned, the variable resistance layer 260 may be protected by the spacer 265, and the spacer 265 may serve as a reference in the etching process. Since the spacer 265 is precisely interlocked with the variable resistance layer 260, the pattern of the selector layer 240A may be aligned by the spacer 265 when the etching process is performed. As a result, since self-alignment is possible in the subsequent process, the accuracy of the pattern may be increased.

Further, according to the method for fabricating a semiconductor device described above, since the width of the upper portion of the variable resistance layer 260 is reduced according to the patterning characteristics of the variable resistance layer 260, the alignment error with respect to the lower portion may be compensated for. When the upper portion becomes small and the selector layer 240A and the variable resistance layer 260 need to be precisely aligned, the small width of the upper portion may make the alignment error with the wide lower portion less sensitive. Therefore, the allowable range for misalignment may be widened. Further, as the width of the upper portion of the variable resistance layer 260 becomes small, the upper pattern may be formed more precisely in a small area. This may reduce the possibility of the occurrence of misalignment, minimize the possibility of misalignment, reduce the etching range in the patterning process, and facilitate the process control. Further, according to the embodiment of the present disclosure, the misalignment may be compensated for by using the area which is less occupied by the upper portion of the variable resistance layer 260 than by the lower portion of the variable resistance layer 260. In the patterning process, the structure in which the upper portion of the variable resistance layer 260 is small may provide flexibility in the alignment between the lower portion of the variable resistance layer 260 and the selector layer 240A, which is effective in decreasing the rate of the occurrence of misalignment.

According to the embodiment of the present disclosure, it is possible to sufficiently perform a wet cleaning process during the patterning of the second conductive line and prevent an electrical short from occurring between the second conductive lines in the semiconductor device, and the method for fabricating the same.

Further, according to the embodiment of the present disclosure, it is possible to control the occurrence of shunt failure during the patterning of the variable resistance layer and prevent deterioration of the selector layer.

While the present invention has been described with respect to the specific embodiments, it will be apparent to those skilled in the art that various changes and modifications may be made without departing from the field and scope of the present disclosure. Furthermore, the embodiments may be combined to form additional embodiments.

## Claims

1. A semiconductor device comprising:
a first conductive line including an upper portion of a carbon-based thin layer;
a variable resistance layer disposed over the first conductive line;
a selector layer disposed over the variable resistance layer, with a carbon-based thin layer disposed thereon; and
a second conductive line disposed over the selector layer.

2. The semiconductor device of claim 1, further comprising a lower electrode layer disposed between the variable resistance layer and the first conductive line and electrically connected to the variable resistance layer.

3. The semiconductor device of claim 2, wherein the lower electrode layer includes titanium nitride.

4. The semiconductor device of claim 1, further comprising an upper electrode layer disposed between the selector layer and the second conductive line, the upper electrode layer including a lower portion of a carbon-based thin layer electrically connected to the selector layer.

5. The semiconductor device of claim 4, wherein the upper electrode layer includes titanium nitride.

6. The semiconductor device of claim 1, further comprising a spacer disposed on a sidewall of the variable resistance layer, the spacer including a material selected from a group including silicon nitride, tantalum nitride, tungsten, titanium nitride, aluminum oxide, hafnium oxide, and platinum.

7. The semiconductor device of claim 1, further comprising an intermediate electrode layer having a planarized upper surface between the variable resistance layer and the selector layer.

8. The semiconductor device of claim 1, further comprising an inter-layer capping layer disposed on a sidewall of the variable resistance layer,
wherein the inter-layer capping layer has a single-layer structure or a multi-layer structure including at least one of a dielectric material and polysilicon.

9. The semiconductor device of claim 1, further comprising a gap-fill layer disposed on a sidewall of the variable resistance layer and the selector layer,
wherein the gap-fill layer includes at least one of silicon oxide, silicon nitride, silicon oxynitride, and silicon oxide carbon nitride.

10. The semiconductor device of claim 1, wherein:
the first conductive line extends in a first direction; and
the second conductive line extends in a second direction intersecting with the first direction.

11. A method for fabricating a semiconductor device, the method comprising:
forming a variable resistance layer over a first conductive line having an upper portion of a carbon-based thin layer and a lower portion of a conductive material;
patterning the variable resistance layer to have a pillar shape;
forming a selector layer over the patterned variable resistance layer;
performing a first lithography process and a first etching process onto the selector layer;
performing a second lithography process and a second etching process onto the selector layer to provide a patterned selector layer; and
forming a second conductive line over the patterned selector layer.

12. The method of claim 11, further comprising forming, after forming the selector layer, an upper electrode layer on the selector layer, the upper electrode layer including a lower portion of a carbon-based thin layer.

13. The method of claim 11, further comprising:
forming a spacer by depositing a material selected from a group including silicon nitride, tantalum nitride, tungsten, titanium nitride, aluminum oxide, hafnium oxide, and platinum on a sidewall of the patterned variable resistance layer.

14. The method of claim 13, wherein a side surface portion of the spacer and a side surface portion of the selector layer are self-aligned during the first patterning process and the second patterning process of the selector layer.

15. The method of claim 11, further comprising, after patterning the variable resistance layer:
forming an intermediate electrode layer; and
planarizing the intermediate electrode layer.

16. The method of claim 11, further comprising, after patterning the variable resistance layer forming an inter-layer capping layer disposed on a side surface of the variable resistance layer,
wherein the inter-layer capping layer has a single-layer structure or a multi-layer structure including at least one of a dielectric material and polysilicon.

17. The method of claim 11, further comprising forming a gap-fill layer to fill a space between sidewalls of the variable resistance layer and the selector layer which is aligned,
wherein the gap-fill layer includes at least one of silicon oxide, silicon nitride, silicon oxynitride, and silicon oxide carbon nitride.

18. The method of claim 11, wherein the first etching process is performed on at least a portion of the carbon-based thin layer of the first conductive line.

19. The method of claim 11, wherein the first etching process is performed on at least a portion of the conductive material of the first conductive line.

20. The method of claim 11, wherein the second etching process is performed on at least a portion of the carbon-based thin layer of the first conductive line.

21. The method of claim 11, wherein the first conductive line is formed to extend in a first direction, and the second conductive line is formed to extend in a second direction intersecting with the first direction.
